Europäisches Patentamt

European Patent Office

Office européen des brevets

(11) Publication number: **0 409 482 A1**

# EUROPEAN PATENT APPLICATION

(21) Application number: 90307608.1

(22) Date of filing: 11.07.90

(51) Int. Cl.⁵: **C08L 81/06**, C08L 67/02

(30) Priority: 21.07.89 GB 8916733
18.08.89 GB 8918938
20.07.89 US 382114

(43) Date of publication of application:
**23.01.91 Bulletin 91/04**

(84) Designated Contracting States:
**AT BE CH DE DK ES FR GB GR IT LI LU NL SE**

(71) Applicant: **IMPERIAL CHEMICAL INDUSTRIES PLC**
**Imperial Chemical House, Millbank**
**London SW1P 3JF(GB)**

(72) Inventor: **Cox, Michael Kenneth**
**c/o ICI Japan Limited, Japanese Technical Centre**
**47 Wadai, Tsukuba, Ibaraki(JP)**
Inventor: **Miles, Isobel Sloan**
**46 High Street, Swainby**
**Northallerton, North Yorkshire(GB)**

(74) Representative: **Roberts, Jonathan Winstanley et al**
**Imperial Chemical Industries PLC Legal Department;Patents Bessemer Road PO Box 6**
**Welwyn Garden City Hertfordshire AL7 1HD(GB)**

(54) **Polymer blend articles.**

(57) A surface mount article e.g. surface mount electronic components and circuit boards, comprises a polymeric blend having a polymeric component which comprises 1% to 90% of a polyarylethersulphone, particularly one having sat least 50 mole % of repeat units -Ph-SO₂-Ph-O- (where Ph is 1,4-phenylene), and 99% to 10% by weight of a melt processable aromatic copolyester which is capable of forming an anisotropic melt phase apart from the blend. Articles made from such blends show good resistance to soldering, especially vapour phase soldering, conditions.

EP 0 409 482 A1

EP 0 409 482 A1

POLYMER BLEND ARTICLES

This invention relates to articles made from polymeric blends of polyarylethersulphone and thermotropic aromatic copolyesters.

US Patent Specification No 4460736 (Froix et al , issued 17th July 1984) discloses polyarylethersulphone/thermotropic aromatic copolyester blends consisting of 5% to 75% by weight of a polyarylethersulphone selected from polymers, or mixtures thereof, having recurring units of formula AI or of formula AII:-

AI -Ph-SO$_2$-Ph-O-

AII -O-Ph-C(CH$_3$)$_2$-Ph-O-Ph-SO$_2$-Ph-

where Ph is 1,4-phenylene,

and 25% to 95% by weight of a melt processable, wholly aromatic polyester which is capable of forming an anisotropic melt phase apart from the blend. In particular, it describes such blends in which the proportions of polyarylethersulphone and polyester are 5% to 40% and 60% to 95%, respectively, which is said to give unexpectedly good mechanical properties. It also describes blends in which the polyester is one of three preferred types listed below.

The preferred polyesters are:-

a) copolyesters consisting essentially of recurring moieties AIA, AIIA, AIIIA and AIVA below:

AIA -O-Ph-CO- ,

AIIA -CO-Np-CO- ,

AIIIA is a symmetrical dioxyaryl moiety of formula -OArO- where Ar is a divalent radical comprising at least one aromatic ring

IVA -CO-Ph-CO- or -O-mPh-O- ,

where Ph is 1,4-phenylene, Np is 2,6-naphthylene and mPh is 1,3-phenylene;

b) copolyesters consisting essentially of recurring moieties AIB, AIIB and AIIIB below:

AIB -O-Ph-CO- ,

AIIB -O-Np-O- ,

AIIIB -CO-Ph-CO- ; and

where Ph is 1,4-phenylene and Np is 2,6-naphthylene;

c) copolyesters consisting essentially of recurring moieties AIC, AIIC, AIIIC and AIVC below:-

AIC -O-Ph-CO-

AIIC -CO-Ph-O-(CH$_2$)$_2$-O-Ph-CO-

AIIIC -CO-Ph-CO-

AIVC -O-Ph'-O-

where Ph is 1,4-phenylene and Ph' is 1,4-phenylene substituted by R which is methyl, chloro, bromo or mixtures thereof, preferably methyl.

European published Patent Application No 0209391 A, Sumitomo Chemical Co. Ltd., describes polymer composites of a thermoplastic resin, which is preferably an aromatic polyether ketone, but can instead be a polyphenylene sulphide, a polyether sulphone or a polyimide, reinforced with fibres made by melt spinning an aromatic polyester exhibiting anisotropy when melted. The composite is processed so that the fibres of the aromatic polyester retain their form and properties so as to reinforce the product made from the composite.

One of the applications for which polymeric blends are considered is for use in the electrical and electronics industry for moulded articles such as circuit boards, connectors, switches, relays, coil bobbins and like devices. Modern manufacturing techniques for such items has led to the requirement that the electrical and/or electronic devices mounted on such articles be mounted on the same surface of the articles as on which the connections, e.g. solder tracks, between the devices are mounted (as compared to the former practice of mounting the devices and the connections on opposite sides of for example a circuit board), thus allowing techniques such as vapour phase soldering to be used to connect the devices. Articles for use in such applications are hereinafter, both in the description and claims, referred to as "surface mount capability articles" or ("SMC articles" for short).

Consequently, SMC articles require chemical resistance and heat performance properties which will enable them to be used in manufacturing processes using techniques such as vapour phase soldering. It has been found that, when used for SMC articles, many polymers and polymeric blends including polyarylethersulphones have a tendency to exhibit foaming and gross dimensional instability under the conditions found in vapour phase soldering processes.

We have now found that certain polymer blends containing polyarylethersulphone and thermotropic

2

aromatic copolyester exhibit surprisingly good foam resistance and dimensional stability under such conditions. By the term 'polymer blend' is meant a combination of at least two polymers that has been made by melt processing the polymers usually including subjecting the melt to shear under conditions such that each polymer of the blend is in the melt phase. The melt processing serves to generate a very intimate blending of the polymers, either as a single phase or as a finely divided dispersion of one polymer in the (an) other. The solid product made by cooling the liquid blend has a morphology which is markedly different from a physical mixture of the individual polymers from which it is made.

Accordingly, the present invention provides, a surface mount capability article which comprises a polymeric blend having a polymeric component which comprises 1% to 90%, preferably 20% to 90% and more particularly 30% to 80%, by weight of a polyarylethersulphone selected from polymers, or mixtures thereof, having recurring units of formula I or formula II:

I -Ph-SO₂-Ph-O-

II -O-Ph-C(CH₃)₂-Ph-O-Ph-SO₂-Ph-

where Ph is 1,4-phenylene;

and 99% to 10%, preferably 80% to 10%, more particularly 70% to 20%, by weight of a melt processable aromatic copolyester which is capable of forming an anisotropic melt phase apart from the polymer blend.

The invention includes the use of a polymeric blend having a polymeric component which comprises 1% to 90%, preferably 20% to 90% and more particularly 30% to 80%, by weight of a polyarylethersulphone selected from polymers, or mixtures thereof, having recurring units of formula I or formula II:

I -Ph-SO₂-Ph-O-

II -O-Ph-C(CH₃)₂-Ph-O-Ph-SO₂-Ph-

where Ph is 1,4-phenylene;

and 99% to 10%, preferably 80% to 10%, more particularly 70% to 20%, by weight of a melt processable aromatic copolyester which is capable of forming an anisotropic melt phase apart from the polymer blend in the manufacture of a surface mount capability article.

Preferred polyarylethersulphones used in the invention include polymers which consist substantially only of recurring units of formula I or formula II as well as copolymers incorporating such units. Commercially available polyarylethersulphone polymers which consist substantially only of recurring units of formula I or formula II include the homopolymers having recurring units of formula I, available from Imperial Chemical Industries under the tradename Victrex PES, and the homopolymers having recurring units of formula II available from Amoco under the tradename Udel. In the case of copolymers, preferably the polymers comprise at least 50 mole % of repeating units of formula I similarly to the homopolymer comprised by recurring units of formula II. Other units which can conveniently be included in the polyarylethersulphones used in the invention can be selected from the following moieties:-

i -Ph-A-Ph-O-

where Ph is as defined above and A is C₁ to C₆, alkyl (other than 2,2-propyl which, with repeating units of formula I would give repeating units of formula II) which may be cyclic, Ph, CO or, particularly, a direct link; or

ii moieties which are polynuclear aromatic units such as those derived from the naphthalene series; the said other units being connected to adjacent units by ether linkages.

In one embodiment of the invention, a preferred copolyester comprises moieties V, VI and VII having the structural formula:-

V -O-Ph-CO-

VI -O-Ph-O-

VII -CO-mPh-CO-

and at least one moiety VIII selected from those of formula:-

-O-Ph-O-Ph-O- -O-Np-O- -O-Ph-Ph-O-

-O-Ph-O-Ph-CO- -O-Np-CO- -CO-Ph-Ph-CO-

-O-Ph-SO₂-Ph-O- -CO-Np-CO- -O-mPh-O-

-O-Ph-C(CH₃)₂-Ph-O- -O-mPh-NH-

where Ph is 1,4-phenylene, mPh is 1,3-phenylene and Np is 2,6-naphthylene;

wherein the copolyester comprises at least 15 mole %, and less than 40 mole % of moieties V, at least 57.5 mole % and less than 84.75 mole % of moieties VI and VII taken together, the number of moieties VI being substantially equal to the number of moieties VII, and at least 0.25 mole % and less than 2.5 mole % of moieties VIII. Preferably, the copolyester comprises between 0.5 and 2.0 mole % of moieties VIII and preferably, the copolyester comprises at least 27 mole % of moieties V.

The preferred copolyesters used in polymeric blends from which articles according to the invention are made are more particularly described and claimed in European published patent application EP 0275164 A.

The polymeric blends from which articles according to the invention are made may also comprise 50% to 95% by weight of the polymeric component and 50% to 5 % by weight of a filler and/or reinforcement, e.g. powdered minerals such as glass, powdered calcium carbonate (ground or precipitated), talc, mica or clay and fibres such as glass, carbon or other organic or inorganic fibres. Preferably, such blends comprise 10% to 40% by weight of the filler and/or reinforcement and the filler and/or reinforcement comprises glass.

The invention is illustrated by the following Examples. All parts and percentages are by weight unless otherwise stated.

Materials used

Victrex PES 3600P and Victrex PES 4100G

These are grades of polyarylethersulphone consisting essentially of repeating units of formula I available from Imperial Chemical Industries PLC ("ICI");

SRP 1500P, SRP 1500G and SRP 2300G

These are grades of copolyester made by ICI. The grades SRP 1500P and 1500G consist essentially of about 36 mole % of 4-hydroxybenzoic acid, about 1 mole % of 6-hydroxy-2-naphthoic acid with the balance being approximately equimolar amounts of hydroquinone and isophthalic acid. The grade SRP 2300G consists essentially of about 73 mole % of 4-hydroxybenzoic acid and 27 mole % of 6-hydroxy-2-naphthoic acid;

Test Methods

Solder Dip Test (Dip Test)

This test is carried out by dipping moulded test pieces into a solder bath at 260° C for predetermined periods of time. The condition of the tested samples is evaluated according to the following categories:
N - no foaming or distortion was observed.
A - just starting to foam at the edges
B - noticeable foaming at the edges
C - significant foaming but negligible distortion
D - severe foaming and lateral distortion
E - gross foaming and distortion
F - gross foaming and curling.

Vapour Phase Solder Resistance Test (Vapour Phase Test)

This test is carried out by exposing test pieces prewarmed for 10 minutes at 85° C to a vapour phase of Fluorinert FC 70 (trade name) at 215° C or of Fluorinert FC 71 (trade name) at 253° C for 30 seconds followed by exposure to a vapour phase of Arklon P (trade name) at 95° C for 30 seconds. The vapour producing materials are available from Minnesota Mining and Manufacturing Co. The condition of the tested samples is evaluated as described above for the Dip Test.

Example 1

Polymer blends 1 to 3 were made by drying Victrex PES 3600P and SRP 1500P polymers in granule form at 150° C and then dry mixing the granules in a Henschel mixer in the proportions set out in Table 1 below. The dry mixes were then blended and compounded with 30% by weight of chopped strand glass fibre using a co-rotating twin-screw compounding extruder (Werner & Pfleider ZSK-30) at about 340° C. The

4

extruded laces were water-bath quenched, superficially dried and cut into pellets of polymer blends 1 to 3. The pellets of the polymer blends were dried at 150°C and were then injection moulded, at a barrel temperature in the range 310°C to 340°C, at an injection pressure of 100 bar (10 MPa) and a mould temperature of 140°C, into standard tensile bars, thickness 3.2 mm, and standard flame test strips (flame strips), thickness 1.6 mm.

The tensile bars and flame strips were conditioned by immersing in water for 2 days and then were towel dried. The samples were dip tested, the tensile bars for 15, 30 and 60 seconds and the flame strips for 10, 20 and 30 seconds.

Further flame strips were vapour phase tested and the results are included in Table 2 below. The "dry" tests were done on samples kept dry after extruding and the "wet" tests were done on samples which had been immersed in water for 2 days and towel dried.

Example 2

A number of blends were prepared from granular form Victrex PES 4100G and SRP 1500G or SRP 2300G which had been dried at 150°C overnight in a air circulating oven. The composition of the blends are given in Table II below. Blends 4C to 8C are comparative blends and 9 to 15 are blends in accordance with the invention. 'Blends' 4C and 5C were 100% of PES 4100G and of SRP 1500G, respectively. Blends 10 to 13 and 15 were compounded by dry mixing the respective polymers and extruding them using a single screw compounding extruder (Plaston) at about 330°C to 370°C. The extruded lace was water-bath quenched, superficially dried and cut into pellets. The pellets were dried at 150°C overnight in the air circulating oven. Blends 6C to 8C, 9 and 14 were formulated by hand mixing blends 11, 12 or 13 with the appropriate amount of PES 4100G or SRP 1500G. Tensile bars, thickness 3.2 mm, were then moulded. Blends 4C and 6C to 8C were moulded at barrel temperatures of about 330°C to 360°C and a mould temperature of 150°C. Blend 9 was moulded at barrel temperatures of about 320°C to 355°C and a mould temperature of 150°C. Blends 10 to 15 were moulded at barrel temperatures of about 320°C to 340°C and a mould temperature of 150°C except for blend 5 for which a mould temperature of 100°C was used.

The dry tensile bars were subjected to the solder dip test. The results are set out in Table 3 below.

The degree of maintenance of stiffness of the polymer blends with increasing temperature was examined by Dynamic Mechanical Analysis techniques using a Polymer Laboratories Dynamic Mechanical Thermal Analyser (DMTA) with the power head attachment. The test samples were obtained by injection moulding the blends into tensile bars for measurement of tensile strength according to ASTM 638. The tabs at the ends of the tensile bars, that is excluding the portions of reduced width, were cut of for use as the test pieces. The test pieces were mounted in the instrument in a single cantilever mode with an interclamp length of approximately 19mm. After mounting in the DMTA, the test pieces were scanned at 2°C. min$^{-1}$ from 25°C to 250°C using a driving frequency of 10 Hz, at a strain setting of x4. The results were calculated using standard Polymer Laboratories software on a Hewlett Packard 310 system. The blends having >5% of PES 4100G exhibited a first Tg at about 140°C and a second Tg at about 230°C. Blends 9 to 14 exhibit a good retention, i.e. > about 50%, of the dynamic modulus (>1GPa) at temperatures above the first Tg as compared to the modulus at temperatures below the first Tg.

TABLE I

| Blend No | PES 3600P (% wt) | PES 4100G (% wt) | SRP 1500G (% wt) | SRP2300G (% wt) |
|---|---|---|---|---|
| 1 | 80 | - | 20 | - |
| 2 | 60 | - | 40 | - |
| 3 | 40 | - | 60 | - |
| 4 | - | 100 | - | - |
| 5 | - | - | 100 | - |
| 6 | - | 99 | 1 | - |
| 7 | - | 98 | 2 | - |
| 8 | - | 95 | 5 | - |
| 9 | - | 90 | 10 | - |
| 10 | - | 80 | 20 | - |
| 11 | - | 70 | 30 | - |
| 12 | - | 60 | 40 | - |
| 13 | - | 50 | 50 | - |
| 14 | - | 25 | 75 | - |
| 15 | - | 50 | - | 50 |

TABLE 2

| Blend No | Dip Test | | | | | | Vapour Phase Test | | | |
|---|---|---|---|---|---|---|---|---|---|---|
| | Tensile bars | | | Flame strips | | | 215°C | | 253°C | |
| | 15 | 30 | 60 | 10 | 20 | 30 | Dry | Wet | Dry | Wet |
| 1 | C | C | D | C | C | C | N | D | C | D |
| 2 | C | C | C | C | C | C | N | A | B | D |
| 3 | C | C | C | C | C | C | N | N | N | A |

TABLE 3

| | Dip Time (Seconds) | | | | |
|---|---|---|---|---|---|
| | | | | | |
| 4 | A | A | B | F | F |
| 5 | A | A | A | A | A |
| 6 | A | B | B | F | F |
| 7 | A | A | A | F | F |
| 8 | A | A | A | F | F |
| 9 | A | A | A | C | F |
| 10 | A | A | B | A | E |
| 11 | A | A | A | A | C |
| 12 | A | A | A | A | B |
| 13 | A | A | A | A | A |
| 14 | A | A | A | A | A |
| 15 | A | A | A | B | C |

6

## Claims

1 A surface mount capability article comprising a polymeric blend having a polymeric component which comprises 1% to 90% by weight of a polyarylethersulphone selected from polymers, or mixtures thereof, having recurring units of formula I or formula II

I -Ph-SO$_2$-Ph-O-

II -O-Ph-C(CH$_3$)$_2$-Ph-O-Ph-SO$_2$-Ph-

where Ph is 1,4-phenylene;

and 99% to 10% by weight of a melt processable aromatic copolyester which is capable of forming an anisotropic melt phase apart from the polymeric blend.

2 An article as claimed in claim 1, in which the polymeric component comprises 20% to 90% of the polyarylethersulphone.

3 An article as claimed in either claim 1 or claim 2, which includes at least one polyarylethersulphone having recurring units connected by ether linkages and comprising at least 50 mole % of recurring units of formula I:

I -Ph-SO$_2$-Ph-O- where Ph is 1,4-phenylene.

4 An article as claimed in any one of claims 1 to 3, which includes at least one polyarylethersulphone having recurring units of formula I either alone or together with units of formula IIA

I -Ph-SO$_2$-Ph-O-

IIA -O-Ph-A$'$-Ph-O-

where Ph is 1,4-phenylene; and

A$'$ is C$_1$ to C$_6$ alkyl, which may be cyclic, Ph, CO or a direct link;

and/or polynuclear aromatic units linked to adjacent units by ether linkages.

5 An article as claimed in any one of claims 1 to 4 in which the polymeric component comprises 80% to 10% of the copolyester.

6 An article as claimed in any one of claims 1 to 5, in which the copolyester comprises moieties V, VI and VII having the structural formulae:

V -O-Ph-CO-

VI -O-Ph-O-

VII -CO-mPh-CO-

and at least one moiety VIII selected from those of formulae:

-O-Ph-O-Ph-O- , -O-Np-O- , -O-Ph-Ph-O- ,

-O-Ph-O-Ph-CO- , -O-Np-CO- , -CO-Ph-Ph-CO- ,

-O-Ph-SO$_2$-Ph-O- , -CO-Np-CO- , -O-mPh-O- ,

-O-Ph-C(CH$_3$)$_2$-Ph-O- , -O-mPh-NH- ,

where Ph is 1,4-phenylene, mPh is 1,3-phenylene and Np is 2,6-naphthylene;

wherein the copolyester comprises at least 15 mole %, and less than 40 mole % of moieties V, at least 57.5 mole % and less than 84.75 mole % of moieties VI and VII taken together, the number of moieties VI being substantially equal to the number of moieties VII, and at least 0.25 mole % and less than 2.5 mole % of moieties VIII.

7 An article as claimed in claim 6, in which the copolyester comprises between 0.5 and 2.0 mole % of moieties VIII.

8 An article as claimed in either claim 6 or claim 7, in which the copolyester comprises at least 27 mole % of moieties V.

9 An article as claimed in any one of claims 1 to 8, in which the polymeric blends comprise 50% to 95% by weight of the polymeric component and 50% to 5 % by weight of a filler and/or reinforcement.

10 A surface mount capability article comprising a polymeric blend having a polymeric component which comprises 1% to 90% by weight of at least one polyarylethersulphone having recurring units connected by ether linkages and comprising at least 50 mole % of recurring units of formula I:

I -Ph-SO$_2$-Ph-O- where Ph is 1,4-phenylene,

and 99% to 10% by weight of a melt processable aromatic copolyester which is capable of forming an anisotropic melt phase apart from the polymeric blend.

11 A surface mount capability article comprising a polymeric blend having a polymeric component which comprises 1% to 90% by weight of at least one polyarylethersulphone having recurring units of formula I either alone or together with units of formula IIA and/or polynuclear aromatic units linked to adjacent units by ether linkages

I -Ph-SO$_2$-Ph-O-

IIA -O-Ph-A$'$-Ph-O-

wherein Ph is 1,4-phenylene and A$'$ is C$_1$ to C$_5$ alkyl, which may be cyclic, Ph, CO or a direct link;

the recurring units of formula I comprising at least 50 mole % of the polyarylethersulphone;

and 99% to 10% by weight of a melt processable aromatic copolyester which is capable of forming an anisotropic melt phase apart from the polymeric blend.

European
Patent Office

EUROPEAN SEARCH
REPORT

Application Number

EP 90 30 7608

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 044 177 (CELANESE) <br> * examples; claims *; & US-A-4460736 (cat. D) <br> – – – | 1-11 | C 08 L 81/06 <br> C 08 L 67/02 |
| X | EP-A-0 121 876 (BASF) <br> * example 2; page 2, lines 30-43; page 3, lines 12-20 * <br> – – – | 1-11 | |
| X | EP-A-0 321 236 (TOSOH) <br> * claims 10,11; examples * <br> – – – | 1-11 | |
| A | DE-A-2 046 963 (IMPERIAL CHEMICAL INDUSTRIES) <br> * claims; examples * <br> – – – | 1-11 | |
| A | EP-A-0 237 275 (CELANESE) <br> * claims * <br> – – – | 1-11 | |
| A | EP-A-0 133 907 (UNION CARBIDE) <br> * claims * <br> – – – – – | 1-11 | |

TECHNICAL FIELDS
SEARCHED (Int. Cl.5)

C 08 L

The present search report has been drawn up for all claims

| Place of search | Date of completion of search | Examiner |
|---|---|---|
| Berlin | 15 October 90 | BOEKER R.B. |